# EUROPEAN PATENT APPLICATION

(11) **EP 4 092 675 A1**
(43) Date of publication of application: **23.11.2022**
(21) Application number: 20943341.6
(22) Date of filing: 11.11.2020
(51) Int. Cl.: G11C 11/406

(54) **SEMICONDUCTOR DEVICE**

(30) Priority: 30.06.2020 CN 202010612720
(71) Applicant: Changxin Memory Technologies, Inc., Hefei, Anhui 230601 (CN)
(72) Inventor: NING, Shuliang, Hefei, Anhui 230601 (CN)
(74) Representative: V.O.
(86) International application number: PCT/CN2020/128136
(87) International publication number: WO 2022/000928

(57) **Abstract**

A semiconductor device, comprising a memory chip (100) and a temperature measurement module (110). The temperature measurement module (110) is used for measuring the temperature of the memory chip (100). The temperature measurement module (110) comprises: a temperature measurement unit (111) used for measuring the temperature of the memory chip (100) and outputting an analog signal corresponding to the temperature; and an A/D conversion module (112) comprising multiple comparison units (Px). Each comparison unit (Px) comprises an input end, a reference end, and an output end; the input ends receive analog signals output by the temperature measurement unit (111); the output ends output digital signals; and reference voltages received by the reference ends of the multiple comparison units (Px) increase non-uniformly. The use of the temperature measurement module (110) for measurement of the temperature of the memory chip (100) prevents the starting and running of the memory chip (100) at a low temperature, thereby shortening the write time and improving the write stability of the memory chip (100); and in addition, the control of the measurement accuracy of different voltage areas ensures the measurement accuracy of areas requiring accurate measurement and improves the measurement efficiency.

## Description

### CROSS-REFERENCE TO RELATED APPLICATION

This application claims priority to Chinese patent application No. 202010612720.9, filed on June 30, 2020 and entitled "Semiconductor Device", the contents of which are hereby incorporated by reference in its entirety.

### TECHNICAL FIELD

The present application relates to the field of memories, and particularly relates to a semiconductor device.

### BACKGROUND

Dynamic Random Access Memory, DRAM is a commonly used semiconductor memory device in computers, and a memory array area of the DRAM consists of many duplicated memory cells. Each of the memory cells usually includes a capacitor and a transistor. A gate electrode of the transistor is connected with a word line, a drain electrode of the transistor is connected with a bit line, and a source electrode of the transistor is connected with the capacitor. Voltage signals on the word line may control the transistor to be turned on or turned off, so that the data information stored in the capacitor may be read through the bit line, or the data information may be written into the capacitor through the bit line for storage.

The temperature has a greater influence on memory writing. When a memory is written in a low-temperature environment, the writing time is longer, and the writing stability is not high.

### SUMMARY

The technical problem to be solved by the present application is to provide a semiconductor device which may measure a temperature of a memory chip to prevent the memory chip from being enabled and run at a low temperature, shorten the writing time and improve the writing stability of the memory chip. In addition, not only the measurement accuracy of a region required to be measured accurately be ensured, but also the measurement efficiency may be improved.

In order to solve the foregoing problem, the present application provides a semiconductor device, including a memory chip and a temperature detection module. The temperature detection module is configured to detect a temperature of the memory chip. The temperature detection module includes: a temperature detection unit, configured to detect the temperature of the memory chip and to output an analog signal corresponding to the temperature; and an Analog/Digital, A/D conversion module including multiple comparison units. Each of the comparison unit includes an input end, a reference end and an output end. The input end receives the analog signal output by the temperature detection unit. The output end outputs a digital signal. Reference voltages received by the reference ends of respective multiple comparison units increase non-uniformly.

Furthermore, a reference voltage increase amplitude in a preset reference voltage range may be lower than a reference voltage increase amplitude in another reference voltage range.

Furthermore, the memory chip may be enabled when the temperature detected by the temperature detection module reaches a set threshold.

Furthermore, the set threshold may correspond to a threshold voltage, and the threshold voltage may be in the preset reference voltage range.

Furthermore, the A/D conversion module may further include a resistor unit, the resistor unit may be provided with multiple leading-out terminals, voltages of the respective multiple leading-out terminals may increase non-uniformly, and the voltages of the respective leading-out terminals may be taken as the reference voltages received by the reference ends of the respective comparison units.

Furthermore, the resistor unit may be provided with a first end and a second end, the first end of the resistor unit may be electrically connected with a power supply, the second end of the resistor unit may be electrically connected with a grounding terminal, and the leading-out terminals may be arranged between the first end and the second end.

Furthermore, the resistor unit may include multiple sub-resistors connected in series, and the numbers of the sub-resistors between respective leading-out terminals of the resistor unit and the second end of the resistor unit may be different from each other, such that the voltages of the respective leading-out terminals are different from each other.

Furthermore, the numbers of the sub-resistors between adjacent respective leading-out terminals in the resistor unit may be the same or different from each other, such that the reference voltages received by the reference ends of the respective multiple comparison units increase non-uniformly.

Furthermore, the number of the sub-resistors between adjacent leading-out terminals in a resistor unit region corresponding to a preset reference voltage may be smaller than the number of the sub-resistors between adjacent leading-out terminals in another region.

Furthermore, each of the sub-resistors may have the same resistance value.

Furthermore, each of the sub-resistors may be a polyresistor, and the sub-resistors may be electrically connected with each other through a first layer of metal wires.

Furthermore, the leading-out terminals of the resistor unit may be formed through a second layer of metal wires.

Furthermore, the A/D conversion module may further include an encoding unit, and the encoding unit may receive and code the digital signal of the comparison unit.

Furthermore, the A/D conversion module may further include an output unit, and the output unit may be connected with the comparison unit, and may be configured to output the digital signal.

Furthermore, the temperature detection unit may include: a fixed resistor provided with a first end and a second end, the first end being electrically connected with a power supply; and a diode connected in series with the fixed resistor, a positive end of the diode being electrically connected with the second end of the fixed resistor, and a negative end of the diode being electrically connected with the grounding terminal.

Furthermore, the temperature detection unit may further include an adjustable resistor, and the adjustable resistor may be connected in parallel with the diode.

Furthermore, the temperature detection unit may be arranged in the memory chip.

Furthermore, the temperature detection unit and the memory chip may share the same grounding terminal.

Furthermore, the temperature detection unit and the memory chip may be powered by different power supplies.

Furthermore, the temperature detection unit may be powered earlier than the memory chip.

Furthermore, the semiconductor device may further include a control chip, and the memory chip and the temperature detection unit may be electrically connected with the control chip.

Furthermore, the control chip may be configured to heat the memory chip before the memory chip is enabled, and to judge whether the temperature detected by the temperature detection unit reaches a set threshold, and to control the memory chip to be enabled if the temperature reaches the set threshold.

The present application has the following advantages. The temperature of the memory chip is detected by the temperature detection module, and the memory chip is enabled when the temperature detected by the temperature detection module reaches the set threshold. The temperature detected by the temperature detection module provides a reference for enabling and running the memory chip, so that the memory chip is prevented from being enabled and run at a low temperature, the writing time is shortened, and the writing stability of the memory chip is improved. In addition, the reference voltages received by the reference ends of the respective multiple comparison units increase non-uniformly to control the measurement accuracy of different voltage regions, so that the measurement accuracy of a region required to be measured accurately may be ensured, the circuit may be saved, and the measurement efficiency may be improved.

### BRIEF DESCRIPTION OF THE DRAWINGS

FIG. 1 is a structure diagram of a first embodiment of a semiconductor device according to the present application.
FIG. 2 is a circuit diagram of a temperature detection module of a semiconductor device according to the present application.
FIG. 3 is a circuit diagram of a resistor unit of a first embodiment of a semiconductor device according to the present application.
FIG. 4 is a circuit diagram of a resistor unit of another embodiment of a semiconductor device according to the present application.
FIG. 5 is a structure diagram of a second embodiment of a semiconductor device according to the present application.
FIG. 6 is a structure diagram of a third embodiment of a semiconductor device according to the present application.
FIG. 7 is a structure diagram of a fourth embodiment of a semiconductor device according to of the present application.
Fig. 8 is a schematic diagram showing electrical connection of a first embodiment of a semiconductor device according to the present application.

### DETAILED DESCRIPTION

Embodiments of a semiconductor device provided in the present application will be described below in detail in combination with the drawings.

As described in background, the temperature has a greater influence on memory writing. When a memory is written in a low-temperature environment, the writing time is longer, and the writing stability is not high.

Researches show that, when an existing memory works in a low-temperature environment, a temperature drop may increase resistance of a bit line, word line, metal connecting wire (metal contact portion), etc., in the memory, and increase of the resistance may change or prolong time for writing data into the memory, influencing the writing stability of the memory.

Therefore, the present application provides a semiconductor device. A temperature of a memory chip is detected by a temperature detection module to provide a reference for enabling and running the memory chip, so that the memory chip is prevented from being enabled and run at a low temperature, writing time is shortened, and the writing stability of the memory chip is improved. In addition, the semiconductor device of the present application may also improve the temperature detection accuracy.

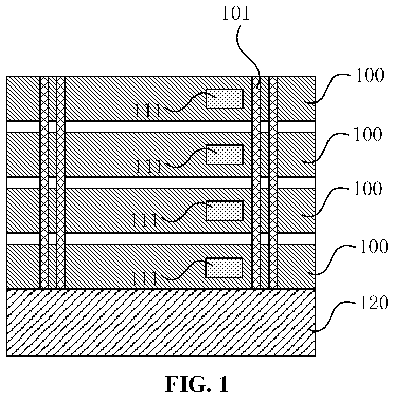

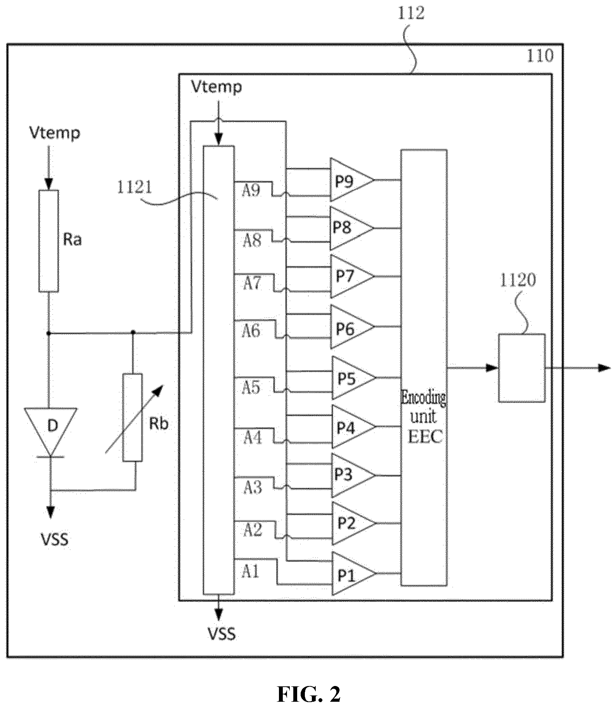

FIG. 1 is a structure diagram of a first embodiment of a semiconductor device according to the present application. FIG. 2 is a circuit diagram of a temperature detection module in a semiconductor device according to the present application. Referring to FIG. 1 and FIG. 2, the semiconductor device of the present application includes a memory chip 100 and a temperature detection module 110.

The semiconductor device further includes a control chip 120, and the memory chip 100 and the temperature detection module 110 are electrically connected with the control chip 120. The control chip 120 is configured to control enabling and running of the memory chip 100 and the temperature detection module 110. Enabling of the memory chip 100 includes power-on and self-detection, and running of the memory chip 100 may include writing data into the memory chip 100, reading data from the memory chip 100, deleting data stored in the memory chip 100, etc.

The memory chip 100 is an existing memory where data writing, data read and/or data deletion may be performed, and the memory chip 100 is formed by a semiconductor integration manufacturing process. Specifically, the memory chip 100 may include a memory array and a peripheral circuit connected with the memory array. The memory array includes multiple memory cells and a bit line, word line and metal connecting wire (metal contact portion) connected with the memory cells. The memory cell is configured to store data, and the peripheral circuit is a related circuit when the memory array is operated. In the embodiment, the memory chip 100 is a DRAM chip, and the DRAM chip includes multiple memory cells. The memory cell usually includes a capacitor and a transistor, a gate electrode of the transistor is connected with a word line, a drain electrode is connected with a bit line, and a source electrode is connected with the capacitor. In another embodiment, the memory chip 100 may be an another type of memory chip.

The temperature detection module 110 is configured to detect a temperature of the memory chip 100 and to supply a signal to the control chip 120. When the temperature detected by the temperature detection module 110 reaches a set threshold, the control chip 120 controls the memory chip 100 to be enabled. A specific magnitude of the set threshold may be set according to a practical requirement or experiences.

The temperature detection module 110 includes a temperature detection unit 111 and an A/D conversion module 112.

The temperature detection unit 111 is configured to detect the temperature of the memory chip 100 and to output an analog voltage signal corresponding to the temperature. The A/D conversion module 112 is configured to convert the analog voltage signal output by the temperature detection unit 111 into a digital signal, and the digital signal is supplied to the control chip 120 as a reference signal whether the memory chip 100 is enabled.

The A/D conversion module 112 includes multiple comparison units Px, and each of the comparison units Px includes an input end, a reference end and an output end. The input end receives the analog voltage signal output by the temperature detection unit 111. The reference end receives a reference voltage signal. The output end outputs a digital signal. The analog voltage signal of the input end is compared with the reference voltage signal of the reference end, and the output end outputs a comparison result, the comparison result being the digital signal.

Reference voltages received by the reference ends of the respective multiple comparison units Px increase non-uniformly, such that reference voltage increase amplitudes in different respective voltage regions are different from each other and thus the measurement accuracy of the voltage regions is changed.

Furthermore, a reference voltage increase amplitude in a preset reference voltage range is lower than a reference voltage increase amplitude in another reference voltage range. Specifically, for a voltage region required to be measured accurately, a low reference voltage increase amplitude may be used to improve the measurement accuracy of the region, and for a voltage region not required to be measured accurately, a high reference voltage increase amplitude may be used to improve the measurement accuracy.

For example, a voltage region 1.2 V to 1.7 V is required to be measured accurately, and corresponds to a reference signal range 1.2 V to 1.7 V. In such case, a reference voltage increase amplitude in the voltage region 1.2 V to 1.7 V may be set to be 0.1 V, so that the number of sampling points is increased, and the measurement accuracy is improved. Reference voltage increase amplitudes in voltage regions of which voltages are less than 1.2 V and voltage regions of which greater than 1.7 V may be set to be 0.3 V, so that the number of the sampling points is reduced as appropriate, the measurement efficiency is improved, and meanwhile used circuits are also reduced.

For another example, for further improving the measurement accuracy, the voltage region 1.2 V to 1.7 V may further be divided into smaller regions, such as a first voltage region 1.2 V to 1.3 V, a second voltage region 1.3 V to 1.5 V and a third voltage region 1.5 V to 1.7 V. In such case, the same reference voltage increase amplitude, such as 0.1 V, may be used for the first voltage region and the third voltage region, and a lower voltage increase amplitude, such as 0.05 V, may be used for the second voltage region.

The preset reference voltage range may be selected according to an enabling temperature of the memory chip 100 to detect the enabling temperature accurately. Specifically, when the temperature detection module 110 detects that the temperature of the memory chip 100 reaches the set threshold, the control chip 120 controls the memory chip 100 to be enabled, the set threshold being the enabling temperature of the memory chip 100. In order to make the temperature detection module 110 detect the set threshold accurately, it is necessary to improve the measurement accuracy of a voltage region with a threshold voltage corresponding to the set threshold and detect the threshold voltage accurately, so that the enabling temperature of the memory chip may be determined accurately. Therefore, the voltage region with the threshold voltage corresponding to the set threshold is set as the preset reference voltage range, and the reference voltage increase amplitude in the preset reference voltage range is lower than a reference voltage increase amplitude in another reference voltage range.

According to the semiconductor device of the present application, the reference voltages received by the reference ends of the respective multiple comparison units increase non-uniformly to control the measurement accuracy of different voltage regions, so that not only may the measurement accuracy of a region required to be measured accurately be ensured, but also the measurement efficiency may be improved.

Furthermore, the present application provides a structure capable of increasing the reference voltages received by the reference ends of the respective multiple comparison units non-uniformly.

Referring to FIG. 2, the A/D conversion module 1121 further includes a resistor unit. The resistor unit 1121 is provided with a first end and a second end. The first end of the resistor unit 1121 is electrically connected with a power supply. The same power supply or different power supplies may be used for the resistor unit 1121 and the temperature detection unit 111. For example, if the A/D conversion module 112 is arranged in the memory chip 100, the same power supply Vtemp may be used for the first end of the resistor unit 1121 and the temperature detection unit 111. If the A/D conversion module 112 is arranged in the control chip 120, different power supplies may be used for the first end of the resistor unit 1121 and the temperature detection unit 111, and a power supply VDD may be used for the resistor unit. The second end of the resistor unit is electrically connected with a grounding terminal VSS.

The resistor unit 1121 is provided with multiple leading-out terminals Ax, voltages of the respective leading-out terminals Ax are different from each other, and the voltages of the respective multiple leading-out terminals Ax increase non-uniformly. Each leading-out terminal Ax is electrically connected with the reference end of the respective comparison unit Px, and the voltage of each leading-out terminal Ax is taken as the reference voltage of the reference end of the respective comparison unit Px. Each of the leading-out terminals Ax corresponds to the respective one of the comparison units Px.

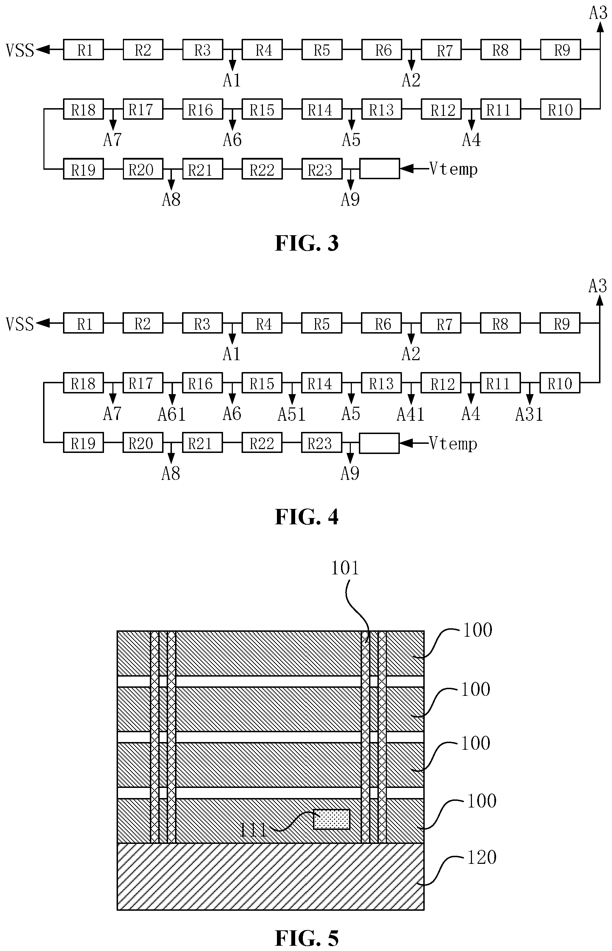

In the embodiment, the resistor unit includes multiple sub-resistors Rn connected in series. Each of the sub-resistors Rn may have the same resistance value. Referring to FIG. 3, a circuit diagram of a resistor unit according to a first embodiment is shown. In the embodiment, each of the sub-resistors Rn has the same resistance value, so that difficulties in layout design are reduced, and simplicity, practicability and convenience for manufacturing are achieved. The numbers of the sub-resistors Rx between adjacent respective leading-out terminals Ax in the resistor unit are the same or different from each other, such that the reference voltages received by the reference ends of the respective multiple comparison units increase non-uniformly. Specifically, for regions with different requirements on measurement accuracy, the numbers of the sub-resistors Rx between adjacent respective leading-out terminals Ax are different from each other, and for regions with the same requirement on measurement accuracy, the numbers of the sub-resistors Rx between adjacent respective leading-out terminals Ax are the same.

For example, in the embodiment, the numbers of the sub-resistors between adjacent respective leading-out terminals in a resistor unit region corresponding to the preset reference voltage are the same but smaller than the number of the sub-resistors between adjacent leading-out terminals in another region, so that the number of sampling points in the resistor unit region corresponding to the preset reference voltage is increased, and furthermore, the measurement accuracy of the region is further improved.

Specifically, referring to FIG. 3, the resistor unit includes sub-resistors R1 to R23 connected in series, a leading-out terminal A1, a leading-out terminal A2, a leading-out terminal A3, a leading-out terminal A4, a leading-out terminal A5, a leading-out terminal A6, a leading-out terminal A7, a leading-out terminal A8, and a leading-out terminal A9. The leading-out terminal A1 is formed in such a way that the three sub-resistors R1, R2 and R3 are arranged between the second end VSS of the resistor unit and the leading-out terminal A1. The leading-out terminal A2 is formed in such a way that the three sub-resistors R4, R5 and R6 are arranged between the leading-out terminal A1 and the leading-out terminal A2. The leading-out terminal A3 is formed in such a way that the three sub-resistors R7, R8 and R9 are arranged between the leading-out terminal A2 and the leading-out terminal A3. The number of the sub-resistors between adjacent respective leading-out terminals of the leading-out terminal A1, the leading-out terminal A2 and the leading-out terminal A3 are the same, i.e., 3. The leading-out terminal A4 is formed in such a way that the two sub-resistors R10 and R11 are arranged between the leading-out terminal A3 and the leading-out terminal A4. The leading-out terminal A5 is formed in such a way that the two sub-resistors R12 and R13 are arranged between the leading-out terminal A4 and the leading-out terminal A5. The leading-out terminal A6 is formed in such a way that the two sub-resistors R14 and R15 are arranged between the leading-out terminal A5 and the leading-out terminal A6. The leading-out terminal A7 is formed in such a way that the two sub-resistors R16 and R17 are arranged between the leading-out terminal A6 and the leading-out terminal A7. The numbers of the sub-resistors between adjacent respective leading-out terminals of the leading-out terminal A3, the leading-out terminal A4, leading-out terminal A5, the leading-out terminal A6 and the leading-out terminal A7 are the same, i.e., 2. The leading-out terminal A8 is formed in such a way that the three sub-resistors R18, R19 and R20 are arranged between the leading-out terminal A7 and the leading-out terminal A8. The leading-out terminal A9 is formed in such a way that the three sub-resistors R21, R22 and R23 are arranged between the leading-out terminal A8 and the leading-out terminal A9. The numbers of the sub-resistors between adjacent respective leading-out terminals of the leading-out terminal A7, the leading-out terminal A8 and the leading-out terminal A9 are the same, i.e., 3. In the embodiment, a range formed by voltages output by the leading-out terminals A3 to A7 is the preset reference voltage range, the voltage increase amplitude therein decreases, and the measurement accuracy is improved.

Furthermore, in another embodiment of the present application, leading-out terminals are arranged between the leading-out terminals A3 to A7 to further increase the number of the sampling points and improve the measurement accuracy. Specifically, referring to FIG. 4, a circuit diagram of a resistor unit of another embodiment is shown. A leading-out terminal A31 is arranged between the leading-out terminals A3 and A4. One sub-resistor is arranged between the leading-out terminal A31 and each of the leading-out terminals A3 and A4. A leading-out terminal A41 is arranged between the leading-out terminals A4 and A5. One sub-resistor is arranged between the leading-out terminal A41 and each of the leading-out terminals A4 and A5. A leading-out terminal A51 is arranged between the leading-out terminals A5 and A6. One sub-resistor is arranged between the leading-out terminal A51 and each of the leading-out terminals A5 and A6. A leading-out terminal A61 is arranged between the leading-out terminals A6 and A7. One sub-resistor is arranged between the leading-out terminal A61 and each of the leading-out terminals A6 and A7.

Furthermore, each of the sub-resistors Rx is a polyresistor, and the sub-resistors are electrically connected with each other through a first layer of metal wires. The leading-out terminals Ax of the resistor unit are formed through a second layer of metal wires. In such a manner, easiness for manufacturing may further be achieved, and the stability and the measurement accuracy may be improved.

The above is only the embodiment of the structure capable of increasing the reference voltages received by the reference ends of the respective multiple comparison units non-uniformly in the present application. In another embodiment of the present application, another structure capable of realizing this function may also be used.

Furthermore, the A/D conversion module 112 further includes an output unit 1120, and the output unit 1120 is connected with the comparison unit Px, and is configured to output the digital signal. Furthermore, in the embodiment, the A/D conversion module 112 further includes an encoding unit EEC, and the encoding unit EEC receives and codes the digital signal output by the comparison unit Px. A signal formed by the encoding unit is input to the output unit 1120, and the output unit 1120 outputs the coded digital signal.

The semiconductor device includes one or more memory chips 100, and the temperature detection module 110 includes one or more temperature detection units 111. The temperature detection unit 111 may be configured to detect temperatures of the one or more memory chips 100. The temperature detection unit 111 may form a one-to-one correspondence or a one-to-multiple correspondence with the memory chip 100.

When the number of the memory chip 100 is one and the number of the temperature detection unit 111 is also one, the temperature detection unit 111 and the memory chip 100 form the one-to-one correspondence, and the temperature detection unit 111 is only configured to detect the temperature of the memory chip 100.

When the number of the memory chips 100 is multiple, and the number of the temperature detection unit 111 is one, the temperature detection unit 111 and the memory chip 100 form the one-to-multiple correspondence, and the temperature detection unit 111 is configured to detect the temperatures of the multiple memory chips 100.

When the number of the memory chips 100 is multiple and the number of the temperature detection units 111 is also multiple, but the number of the temperature detection units 111 is smaller than the number of the memory chips 100, the temperature detection units 111 and the memory chips 100 may form both the one-to-one correspondence and the one-to-multiple correspondence, or only form the one-to-multiple correspondence. That is, there may be a case that one temperature sensitive unit 111 detects the temperature of only one memory chip 100 and one temperature sensitive unit 100 detects the temperatures of multiple memory chips 100, or there is only a case that one temperature sensitive unit 100 detects the temperatures of multiple memory chips 100.

When the number of the memory chips 100 is multiple, the number of the temperature detection units 111 is also multiple, and the number of the temperature detection units 100 is the same as the number of the memory chips 100, the temperature detection units 111 and the memory chips 100 form the one-to-one correspondence, and one temperature detection unit 111 is configured to detect the temperature of one memory chip 100. Specifically, in the embodiment, the number of the memory chips 100 is multiple, and the number of the temperature detection units 111 is also multiple. As shown in FIG. 1, FIG. 1 schematically shows four memory chips 100 and four temperature detection units 111. The multiple memory chips 100 are stacked on each other, and each of the temperature detection units 111 correspond to the respecitve one of the memory chips 100.

Furthermore, referring back to FIG. 2, in the embodiment, the temperature detection unit 111 includes a fixed resistor Ra and a diode D. The fixed resistor Ra is provided with a first end and a second end, and the first end is electrically connected with a power supply Vtemp. The diode D is connected in series with the fixed resistor Ra, a positive end of the diode D is connected with the second end of the fixed resistor Ra, and a negative end of the diode D is electrically connected with the grounding terminal VSS. The diode D is sensitive to temperature, a current of the diode D changes with an ambient temperature, and furthermore, the diode may be configured to measure the ambient temperature.

Furthermore, in the embodiment, the temperature detection unit 111 further includes an adjustable resistor Rb, and the adjustable resistor Rb is connected in parallel with the diode D, and is configured to calibrate the diode D. A resistance value of the adjustable resistor Rb is variable. For example, the resistance value of the adjustable resistor Rb may be changed under the control of the control chip 120 to calibrate the diode D.

Furthermore, the temperature detection unit 111 may be formed in the memory chip 100 through a semiconductor integration manufacturing process. The temperature detection unit 111 may be formed in the memory chip 100 if the temperature detection unit 111 is configured to detect the temperature of only one memory chip 100. For example, in the embodiment, as shown in FIG. 1, each of the temperature detection units 111 corresponds to the respective one of the memory chips 100, and one temperature detection unit 111 is arranged in each memory chip 100. The temperature detection unit 111, if configured to detect the temperatures of multiple memory chips 100, may be formed in any memory chip 100 in the multiple memory chips 100 or formed in the middle or bottom memory chip 100 of the multiple memory chips 100. For example, in a second embodiment of the present application, referring to FIG. 5, a structure diagram of a second embodiment of a semiconductor device according to the present application is shown. The temperature detection unit 111 is arranged in the bottom memory chip 100, and may detect temperatures of four memory chips 100.

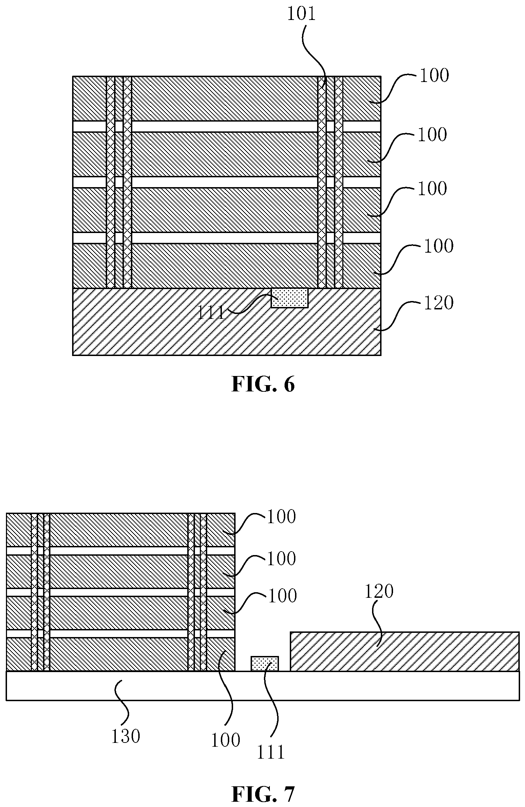

In another embodiment of the present application, the temperature detection unit 111 is not arranged in the memory chip 100 but arranged in the control chip 120. Specifically, referring to FIG. 6, a structure diagram of a third embodiment of a semiconductor device according to the present application is shown. The temperature detection unit 111 is arranged in the control chip 120, and may measure temperatures of four memory chips 100 stacked on the control chip 120.

In another embodiment of the present application, referring to FIG. 7, a structure diagram of a fourth embodiment of a semiconductor device according to the present application is shown. The semiconductor device further includes a circuit substrate 130, a connecting circuit (not shown in the figure) is formed in the circuit substrate 130. Both the memory chip 100 and the control chip 120 are arranged on the circuit substrate 130, and the memory chip 100 is electrically connected with the control chip 120 through the connecting circuit in the circuit substrate 130. In the embodiment, the temperature detection unit 111 is also arranged on the circuit substrate 130 to measure the ambient temperature, and the ambient temperature is approximate to the temperature of the memory chip 100, and may approximately be used as the temperature of the memory chip 100. The circuit substrate 130 includes, but not limited to, a Printed Circuit Board, PCB. It can be understood that, in another embodiment of the present application, the temperature detection unit 111 may not be arranged on the circuit substrate 130, and the temperature detection unit 111 may be arranged in the memory chip 100 or the control chip 120, as shown in FIG. 1, FIG. 5 and FIG. 6.

It is to be noted that, in the embodiment of the present application, functions of the control chip 120 in controlling enabling of the memory chip 100, etc., may also be realized by arranging a control circuit in the memory chip 100, and in such case, the control chip 120 may not be required. Those skilled in the art should understand that the control chip may be arranged as required.

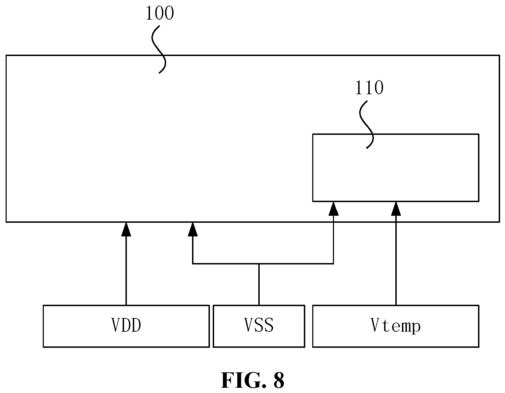

Furthermore, the temperature detection unit 111 and the memory chip 100 are powered by different power supplies. FIG. 8 is a schematic diagram showing electrical connection of a first embodiment of a semiconductor device according to the present application. Referring to FIG. 8, the temperature detection unit 111 is powered by the power supply Vtemp, and the memory chip 100 is powered by the power supply VDD. The grounding terminal VSS, the power supply VDD and the power supply Vtemp are provided by the control chip 120. Since the temperature detection unit 111 and the memory chip 100 are powered by different power supplies, power supply to the temperature detection unit 111 and the memory cell 100 may be controlled independently of each other to enable the temperature detection unit 111 and the memory chip 100 at different time.

Accordingly, in the present application, the temperature detection unit 111 and the memory chip 100 may be controlled to be enabled independently of each other. That is, the temperature detection unit 111 may be enabled no matter whether the memory chip 100 is enabled, so that the temperature of the memory chip 100 may be detected no matter whether the memory chip 100 is enabled, a reference may be provided for enabling and running the memory chip 100, the memory chip 100 may further be prevented from being enabled or run at a low temperature, and the stability of the memory chip 100 is improved.

As described above, the temperature greatly influences the performance of the memory chip 100, particularly when the memory chip 100 is enabled. If the memory chip 100 is enabled at a low temperature, time for writing data into the memory chip 100 may be changed (for example, increased), which influences the writing stability of the memory chip 100. Therefore, the temperature of the memory chip 100 is required to be measured before the memory chip 100 is enabled to ensure that the memory chip 100 may be enabled at an approximate temperature.

Therefore, in the present application, the temperature detection unit 111 is powered earlier than the memory chip 100. That is, the temperature detection unit 111 has been enabled before the memory chip 100 is enabled, and in such a manner, a temperature of the memory chip 100 before being enabled may be obtained to provide a reference for enabling the memory chip 100. A power supply time difference between the temperature detection unit 111 and the memory chip 100 is determined by a temperature change rate of the memory chip 100. If the temperature change rate of the memory chip 100 is high, time for the memory chip 100 to reach a preset temperature is short, so that the power supply time difference between the temperature detection unit 111 and the memory chip 100 is small. If the temperature change rate of the memory chip 100 is low, the time for the memory chip 100 to reach the preset temperature is long, so that the power supply time difference between the temperature detection unit 111 and the memory chip 100 is great.

Furthermore, referring to FIG. 8, the temperature detection unit 111 and the memory chip 100 share the same grounding terminal VSS. This provides the following advantages. On one hand, increase of a leakage current in a case that the memory chip 100 is not enabled may be avoided. On the other hand, the number of pins may be reduced, and the space is saved.

Referring back to FIG. 1, the multiple memory chips 100 are stacked on the control chip 120, and the control chip 120 is bonded with the bottom memory chip 100 in the stacked structure. In another embodiment of the present application, when there is only one memory chip 100, the memory chip 100 is arranged on the control chip 120, and the control chip 120 is bonded with the memory chip 100.

A through-silicon-via interconnect structure 101 is formed in the memory chip 100. Through the through-silicon-via interconnect structure 101, the memory chip 100 is electrically connected with the control chip 120, and the temperature detection unit 111 is electrically connected with the control chip 120. That is, through the through-silicon-via interconnect structure 101, the memory chip 100 is electrically connected with the grounding terminal VSS and the power supply VDD, and the temperature detection unit 111 is electrically connected with the power supply Vtemp and the grounding terminal VSS. Specifically, in the embodiment, when multiple memory chips 100 are stacked on each other, each of the memory chips 100 may be connected with the control chip 120 through the respective one of different silicon-through-via interconnect structures. When there are multiple temperature detection units 111, each of the temperature detection units 111 may be connected with the control chip 120 through the respective one of different through-silicon-via interconnect structures, or the multiple temperature detection units 111 may be connected with the control chip 120 through the same silicon-through-via interconnect structure. It can be understood that the memory chip 100 and the temperature detection unit 111 are connected with the control chip 120 through different silicon-through-via interconnect structures, such that the temperature detection unit 111 and the memory chip 100 may be powered by different power supplies. Furthermore, the multiple temperature detection units 111 may also share the same silicon-through-via interconnect structure for power supply.

In another embodiment, the memory chip 100 and the temperature detection unit may also be electrically connected with the control chip 120 through metal leads (formed by means of a lead bonding process).

If the memory chip 100 in a low-temperature environment is heated, the temperature of the memory chip 100 may be increased rapidly, thereby accelerating enabling of the memory chip 100. Therefore, in the present application, the control chip 120 may also be enabled before the memory chip 100 is enabled, and the control chip 120 heats the memory chip 100 by use of heat generated by the control chip 120 itself after being enabled to increase the temperature of the memory chip 100 rapidly.

After the control chip 120 is enabled, the control chip 120 controls the temperature detection unit 111 to be enabled to detect the temperature of the memory chip 100. The temperature detection unit 111 may further send the detected temperature to the control chip 120 as data of the control chip 120.

The control chip 120 may judge whether the temperature detected by the temperature detection unit 111 reaches the set threshold, and control the memory chip 100 to be enabled if the temperature reaches the set threshold.

If there is only one temperature detection unit 111 and one memory chip 100, and the one temperature detection unit 111 is only configured to detect the temperature of the one memory chip 100, when the control chip 120 judges that the temperature detected by the temperature detection unit 111 reaches the set threshold, the control chip 120 controls the memory chip 100 to be enabled.

If there is one temperature detection unit 111 and multiple memory chips 100, and the temperature detection unit 111 detects temperatures of the multiple memory chips 100, when the control chip 120 judges that the temperatures detected by the temperature detection unit 111 reach the set threshold, the control chip 120 controls the memory chip 100 closest to the control chip 120 to be enabled at first, and then controls the other memory chips 100 above the enabled memory chip to be sequentially enabled.

If there are multiple temperature detection units 111 and multiple memory chips 100, and there may be a case that one temperature detection unit 111 detects a temperature of only one memory chip 100 and one temperature detection unit 111 detects temperatures of the multiple memory chips 100, or there is only a case that one temperature detection unit 111 detects the temperatures of the multiple memory chips 100, the control chip 120, when judging that a temperature detected by a certain temperature detection unit 111 reaches the set threshold, controls the memory chip 100 corresponding to the temperature detection unit 111 to be enabled; and controls the memory chip 100 closest to the control chip 120 to be enabled at first and then controls the other memory chips 100 above the enabled memory chip to be sequentially enabled, if the temperature detection unit 111 detects temperatures of multiple memory chips 100.

If there are multiple temperature detection units 111 and multiple memory chips 100, and each of the temperature detection units 111 corresponds to the respective one of the memory chips 100, the control chip 120, when judging that a temperature detected by a certain temperature detection unit 111 reaches the set threshold, controls the memory chip 100 corresponding to the temperature detection unit 111 to be enabled. Specifically, the stacked structure shown in FIG. 1 includes four memory chips 100, and there is a respective temperature detection unit 111 in each memory chip 100. In such case, each temperature detection unit 111 may detect a temperature of the respective memory chip 100, so that four detected temperature values are obtained. The control chip 120 may sequentially judge whether the temperatures detected by the four temperature detection units 111 reach the set threshold, and if the temperature detected by a certain temperature detection unit 111 reaches the set threshold, the control chip 120 controls the memory chip corresponding to the temperature detection unit 111 to be enabled. For example, when the temperature detected by the temperature detection unit 111 in the bottom memory chip 100 in the stacked structure reaches the set threshold at first, the control chip 120 may control the bottom memory chip 100 in the stacked structure to be enabled at first. Then, when the temperature detected by the temperature detection unit 111 corresponding to the second last memory chip 100 in the stacked structure also reaches the set threshold, a control unit 301 controls the second last memory chip 100 in the stacked structure to be enabled. The other two memory chips 100 above the enabled memory chips are enabled in the same manner.

When the semiconductor device includes multiple memory chips 100, through the abovementioned control structure and control manner, the accuracy of enabling time of each memory chip 100 may further be improved, writing time for writing data into each memory chip 100 in a low-temperature environment may further be shortened, and the writing stability of each memory chip 100 is further improved.

When the semiconductor device of the present application works in a low-temperature environment, the memory chip 100 may be heated to the set threshold through the control chip 120, so that resistance of the bit line, word line and metal connecting wire (metal contact portion) in the memory chip 100 may be prevented from being increased due to the low ambient temperature. Therefore, the writing time for writing data into the memory chip in the low-temperature environment is further shortened, and the writing stability of the memory chip is improved. The set threshold may be set in the control chip 120. A specific magnitude of the set threshold may be set according to a practical requirement or experiences.

In another embodiment, there may be an additional heating circuit (not shown in the figure) in the control chip 120. The heating circuit is configured to heat the memory chip 100. Before or after the control chip 120 heats the memory chip 100, the control chip 120 judges whether the temperature, detected by the temperature detection unit 111, of the memory chip 100 reaches the set threshold. If the temperature does not reach the set threshold, the control chip 120 controls the heating circuit to heat the memory chip 100, and if the temperature reaches the set threshold, the control chip 120 controls the heating circuit to stop heating the memory chip 100. Therefore, a heating process may be controlled accurately to keep the temperature of the memory chip 100 nearby the set threshold to prevent the temperature of the memory chip 100 from being excessively high or low, such that the writing time of the memory is always relatively short.

The above is only the preferred implementation mode of the present application. It should be pointed out that those of ordinary skill in the art may further make a plurality of improvements and embellishments without departing from the principle of the present application, and these improvements and embellishments shall also fall within the scope of protection of the present application.

## Claims

1. A semiconductor device, comprising a memory chip and a temperature detection module, the temperature detection module being configured to detect a temperature of the memory chip, the temperature detection module comprising:
a temperature detection unit, configured to detect the temperature of the memory chip and to output an analog signal corresponding to the temperature; and
an Analog/Digital, A/D conversion module comprising multiple comparison units, wherein each of the comparison units comprises an input end, a reference end and an output end, the input end receives the analog signal output by the temperature detection unit, the output end outputs a digital signal, and reference voltages received by the reference ends of respective multiple comparison units increase non-uniformly.

2. The semiconductor device of claim 1, wherein a reference voltage increase amplitude in a preset reference voltage range is lower than a reference voltage increase amplitude in another reference voltage range.

3. The semiconductor device of claim 2, wherein the memory chip is enabled when the temperature detected by the temperature detection module reaches a set threshold.

4. The semiconductor device of claim 3, wherein the set threshold corresponds to a threshold voltage, and the threshold voltage is in the preset reference voltage range.

5. The semiconductor device of claim 2, wherein the A/D conversion module further comprises a resistor unit, the resistor unit is provided with multiple leading-out terminals, voltages of respective multiple leading-out terminals increase non-uniformly, and the voltages of the respective leading-out terminals are taken as the reference voltage received by the reference end of the respective comparison units.

6. The semiconductor device of claim 5, wherein the resistor unit is provided with a first end and a second end, the first end of the resistor unit is electrically connected with a power supply, the second end of the resistor unit is electrically connected with a grounding terminal, and the leading-out terminals are arranged between the first end and the second end.

7. The semiconductor device of claim 6, wherein the resistor unit comprises multiple sub-resistors connected in series, and the numbers of the sub-resistors between respective leading-out terminals of the resistor unit and the second end of the resistor unit are different from each other, such that the voltages of the respective leading-out terminals are different from each other.

8. The semiconductor device of claim 7, wherein the numbers of the sub-resistors between adjacent respective leading-out terminals in the resistor unit are the same or different from each other, such that the reference voltages received by the reference ends of the respective multiple comparison units increase non-uniformly.

9. The semiconductor device of claim 8, wherein the number of the sub-resistors between adjacent leading-out terminals in a resistor unit region corresponding to a preset reference voltage is smaller than the number of the sub-resistors between adjacent leading-out terminals in another region.

10. The semiconductor device of claim 7, wherein each of the sub-resistors has the same resistance value.

11. The semiconductor device of claim 7, wherein each of the sub-resistors is a polyresistor, and the sub-resistors are electrically connected with each other through a first layer of metal wires.

12. The semiconductor device of claim 11, wherein the leading-out terminals of the resistor unit are formed through a second layer of metal wires.

13. The semiconductor device of claim 5, wherein the A/D conversion module further comprises an encoding unit, and the encoding unit receives and codes the digital signal of the comparison unit.

14. The semiconductor device of claim 5, wherein the A/D conversion module further comprises an output unit, and the output unit is connected with the comparison unit, and is configured to output the digital signal.

15. The semiconductor device of claim 1, wherein the temperature detection unit comprises:
a fixed resistor provided with a first end and a second end, the first end being electrically connected with a power supply; and
a diode connected in series with the fixed resistor, a positive end of the diode being electrically connected with the second end of the fixed resistor, and a negative end of the diode being electrically connected with the grounding terminal.

16. The semiconductor device of claim 15, wherein the temperature detection unit further comprises an adjustable resistor, and the adjustable resistor is connected in parallel with the diode.

17. The semiconductor device of claim 1, wherein the temperature detection unit is arranged in the memory chip.

18. The semiconductor device of claim 17, wherein the temperature detection unit and the memory chip share the same grounding terminal.

19. The semiconductor device of claim 17, wherein the temperature detection unit and the memory chip are powered by different power supplies.

20. The semiconductor device of claim 19, wherein the temperature detection unit is powered earlier than the memory chip.

21. The semiconductor device of claim 1, further comprising a control chip, the memory chip and the temperature detection unit being electrically connected with the control chip.

22. The semiconductor device of claim 21, wherein the control chip is configured to heat the memory chip before the memory chip is enabled, and to judge whether the temperature detected by the temperature detection unit reaches a set threshold, and to control the memory chip to be enabled if the temperature reaches the set threshold.
